# FASCICULE DE BREVET EUROPEEN

(11) **EP 0 472 452 B1**
(45) Date de publication et mention de la délivrance du brevet: **11.10.1995**
(21) Numéro de dépôt: 91402198.5
(22) Date de dépôt: 06.08.1991
(51) Int. Cl.: H01L 29/772, H01L 21/20

(54) **Transistor de puissance et procédé de réalisation**
Leistungstransistor und Verfahren zur Herstellung
Power transistor and its manufacturing process

(30) Priorité: 24.08.1990 FR 9010629
(43) Date de publication de la demande: 26.02.1992
(73) Titulaire: THOMSON-CSF, 75008 Paris (FR)
(72) Inventeur: Hirtz, Jean-Pierre, F-92045 Paris la Défense (FR); Pribat, Didier, F-92045 Paris la Défense (FR)
(74) Mandataire: Guérin, Michel

(56) Documents cités:
- EP-A- 0 073 487
- EP-A- 0 098 111
- EP-A- 0 241 316
- EP-A- 0 281 335
- EP-A- 0 336 831
- US-A- 4 907 053
- EXTENDED ABSTRACTS OF THE 19TH CONFERENCE ON SOLID STATE DEVICES AND MATERIALS, 25 août 1987, Tokyo, JP, pages 179-182 ; K. KUSUKAWA et al. : "MOS-FETs fabricated by SPE-SOI technology"

## Description

L'invention concerne un transistor de puissance et son procédé de réalisation. Elle est applicable à la réalisation de transistors en matériaux semiconducteurs d'un type donné réalisé sur un substrat de type différent, par exemple un transistor en matériau III-V tel que du GaAs sur substrat silicium.

La croissance épitaxiale de GaAs sur silicium offre des ouvertures technologiques importantes dans le domaine des composants de puissance.

Les performances électriques des transistors en GaAs ou matériaux III-V sont bien connues, mais il est connu également que l'arséniure de gallium est cher, fragile et est un mauvais conducteur thermique. Par contre, le silicium est relativement économique, moins fragile, bon conducteur thermique, mais les transistors en silicium ont des performances électriques limitées en fréquence.

Cette opposition entre les caractéristiques du GaAs et du silicium a amené, depuis peu de temps, à réaliser des transistors dans une couche de GaAs épitaxiée sur un substrat de Si : le transistor a les performances du GaAs, il est moins coûteux en matériau semiconducteur, et la plaquette de Si est moins fragile, donc les rendements sont meilleurs.

Cette solution est intéressante pour les transistors faible bruit, de petites dimensions, qui dissipent peu de chaleur au niveau du canal. Elle est difficilement applicable aux transistors de puissance qui dissipent plus de chaleur : pour un transistor délivrant 1 watt aux fréquences millimétriques, la région du canal dissipe 3 watts. Or le canal du transistor repose toujours sur une couche GaAs semi-isolant électrique, pour empêcher le courant de fuir vers le substrat en Si qui est toujours conducteur électrique : il est au mieux très résistif, car on ne sait pas faire de Si isolant électrique. Cette couche de GaAs isolant électrique constitue donc aussi une barrière thermique, qui s'oppose à l'évacuation de la chaleur par le substrat Si.

Selon une technique connue pour un transistor GaAs, sur substrat GaAs (en réalisation massive ou "bulk") la chaleur est pompée par la face arrière, au moyen de trous qui traversent toute l'épaisseur du corps du transistor, et sont bouchés par un métal. Mais la réalisation de ces trous est obtenue au prix d'un procédé compliqué de collage de la plaquette par sa face avant, ou face supérieure, sur un support, suivi d'un rodage du substrat GaAs qui est pratiquement remplacé par un radiateur métallique, en or le plus souvent .

Avec une telle technologie, dite "face arrière", complexe dans sa réalisation, les rendements obtenus sont souvent faibles (inférieurs à 50 %).

De plus, cette technologie est difficilement adaptable aux transistors GaAs/Si.

Selon une autre technique connue, l'une des deux régions d'accès du transistor, c'est-à-dire la source ou le drain, est munie d'un puits thermique métallique qui traverse la ou les couches de GaAs pour être en contact avec le substrat silicium et qui conduit aussi la chaleur dégagée en fonctionnement vers le substrat silicium qui est meilleur conducteur thermique et qui dissipe la chaleur. Cependant cette technique nécessite une couche tampon épaisse de GaAs, entre le substrat de Si et la couche active de GaAs. On perd ainsi une partie significative de l'avantage que constitue la dissipation thermique du silicium.

Enfin, cette technologie du transistor GaAs/Si exige de percer la couche de GaAs au centre du contact de source de façon à interconnecter les sources, via le substrat de Si très fortement dopé. Cette technologie dite via-trou est relativement difficile à mettre en oeuvre pour une structure GaAs/Si.

Le document US 4 907 053 décrit un transistor dans lequel les différentes zones dopées du transistor sont dans un même plan. Ce transistor est réalisé en dopant en surface différentes zones d'une couche en semiconducteur.

L'invention concerne un procédé de réalisation qui permet de mieux calibrer les zones dopées.

En ce qui concerne le procédé de réalisation, les demandes de brevets français n° 88 04 437 et n° 88 04 438 (=EPA-0 336 831) décrivent un procédé de croissance d'une couche de matériau semiconducteur d'un type donné (GaAs par exemple) sur un autre semiconducteur (silicium par exemple) et cela sans défaut.

De plus, la couche peut présenter une modulation de dopage selon le plan de la couche comme cela est décrit dans la demande de brevet français n° 89 04 257.

L'invention concerne donc un procédé de réalisation d'au moins un transistor, caractérisé en ce qu'il comporte les différentes étapes suivantes :
a) réalisation sur un substrat d'une première couche en matériau semiconducteur d'un type déterminé et, sur cette couche, une première couche de confinement en matériau isolant ;
b) réalisation d'une cavité comprise entre la première couche de confinement et une deuxième couche de confinement, cette cavité étant définie par une première et une deuxième faces parallèlesde ces couches, ladite cavité comportant dans son épaisseur au moins un élément en matériau semiconducteur fortement dopé du type déterminé ainsi qu'une ouverture traversant la deuxième couche de confinement et aboutissant sensiblement perpendiculairement à l'une des faces parallèles, lesdites couches de confinement étant en matériaux tels qu'il ne peut y avoir ni nucléation, ni dépôt de semiconducteur ;
b) épitaxie latérale par ladite ouverture, d'un matériau de même type que celui dudit élément de façon à remplir la cavité, le matériau épitaxié étant fortement dopé dans une première partie au début de l'épitaxie puis faiblement dopé dans une deuxième partie et enfin fortement dopé dans une troisième partie en fin d'épitaxie ;
c) retrait de la deuxième couche de confinement comportant l'ouverture ;
d) réalisation d'un contact de source sur la première partie du matériau épitaxié, d'un contact de grille sur la deuxième partie du matériau épitaxié et d'un contact de drain sur la troisième partie du matériau épitaxié.

Les différents objets et caractéristiques de l'invention apparaîtront plus clairement dans la description qui va suivre et dans les dessins annexés qui représentent :
- les figures 1 à 10, un exemple de procédé de réalisation selon l'invention ;
- la figure 11, un arrangement d'un ensemble de transistors selon l'invention ;
- les figures 12 à 15, des variantes de réalisation du dispositif de l'invention.

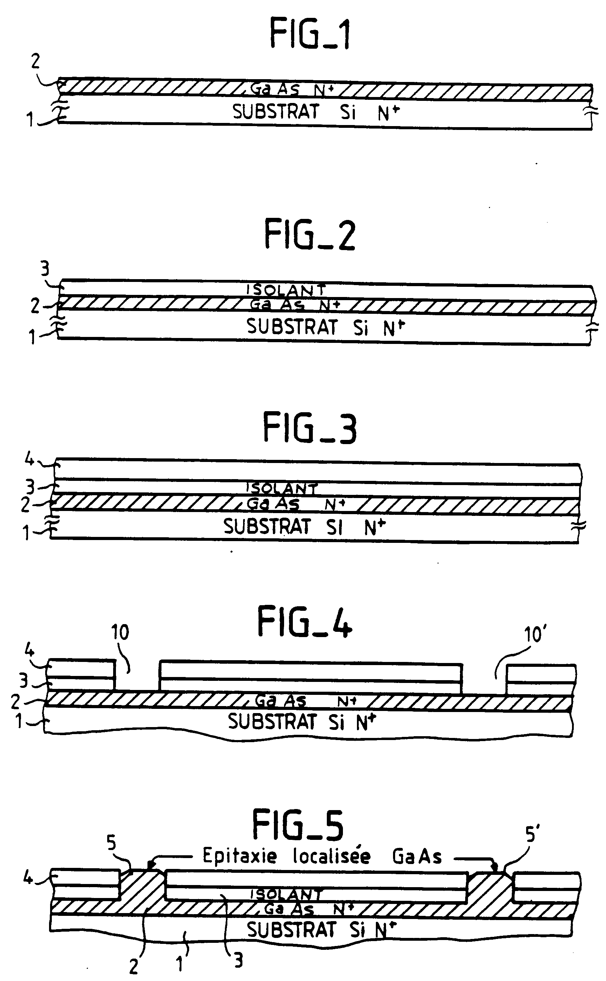

En se reportant aux figures 1 à 10, on va tout d'abord décrire un exemple du procédé de réalisation selon l'invention .

Ce procédé comporte les différentes étapes suivantes :

### ETAPE 1

Sur un substrat 1 de silicium fortement dopé, on réalise une épitaxie de GaAs très fortement dopé, par exemple par MBE ou MOCVD. On obtient une couche 2 en GaAs dopé (figure 1).

### ETAPE 2

Sur cette couche 2 un premier masque (couche 3) en matériau isolant est déposé. Une bonne conduction thermique de ce masque est importante pour la dissipation thermique du MESFET de puissance. Ce masque pourrait être par exemple en Al₂0₃ polycristallin ou en BeO polycristallin ou en diamant polycristallin ou en AIN (figure 2).

### ETAPE 3

Un deuxième masque (couche 4) est déposé sur la couche 3. Ce masque doit présenter une bonne sélectivité d'attaque chimique par rapport au premier masque. Il peut être, par exemple, en silicium amorphe (figure 3).

### ETAPE 4

Des ouvertures 10, 10′ sont réalisées localement dans les deux masques (couches 3 et 4) jusqu'à la surface de GaAs (figure 4).

### ETAPE 5

Une épitaxie localisée et sélective de GaAs fortement dopé est réalisée dans ces ouvertures, par exemple en épitaxie en phase vapeur à base de chlorures. La surface de ce dépôt localisé de GaAs doit affleurer la surface du deuxième masque. On obtient ainsi, dans les ouvertures 10, 10′, les éléments 5, 5′ en GaAs fortement dopé.

### ETAPE 6

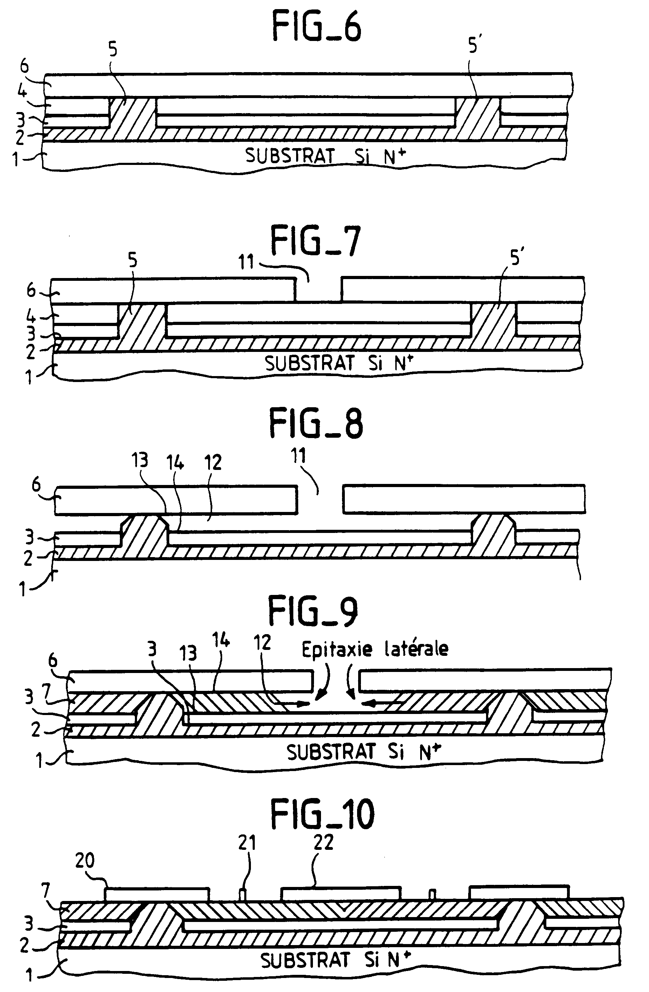

Un troisième masque (couche 6) est déposé sur toute la surface, éléments 5, 5′ et couche 4. Ce troisième masque doit présenter une bonne sélectivité d'attaque par rapport au deuxième masque. Il est, par exemple, en Si₃N_{4.} (figure 6).

### ETAPE 7

Une ouverture 11 au moins est réalisée dans le troisième masque, grâce à une attaque sélective par rapport au deuxième masque. Cette ouverture est réalisée a mi chemin entre les éléments 5, 5′ (voir figure 7).

### ETAPE 8

Le deuxième masque (couche 4) est entièrement attaqué et éliminé grâce à une attaque sélective par rapport aux premier et troisième masques. On obtient ainsi comme cela est représenté en figure 8, une cavité 12 vide de tout matériau sous la couche 6.

### ETAPE 9

La zone active du transistor à fabriquer est ensuite réalisée par épitaxie latérale suivant les procédés décrits dans les demandes de brevet français 88 04 437 et 88 04 438. Les éléments 10, 10′ en GaAs déposés an cours de l'étape 5 précédente, servent de germes de croissance pour l'épitaxie de GaAs à l'intérieur de la cavité 12. Les défauts de croissances se trouvent localisés dans la région proche du germe (élément 5, 5′). Ils sont en effet confinés par les deux interfaces 13 et 14 de la cavité 12. Cette épitaxie latérale offre de plus la possibilité dune modulation de dopage. Pour cela, comme cela est décrit dans la demande de brevet n° 89 04 257, on introduit un gaz dopant durant l'opération dépitaxie de façon à doper le matériau épitaxie dans la cavité 12. Le dopage est réalisé de telle façon qu'au début de l'épitaxie on obtienne un dopage N⁺, puis, par réduction de la pression partielle du gaz dans le réacteur d'épitaxie, on obtient un dopage N, puis à nouveau un dopage N⁺ en réaugmentant la pression partielle du gaz. Ainsi une structure constituée d'une couche 7 plane possédant une modulation latérale serait bien adaptée pour les régions source - grille - drain d'un MESFET (figure 9).

### ETAPE 10

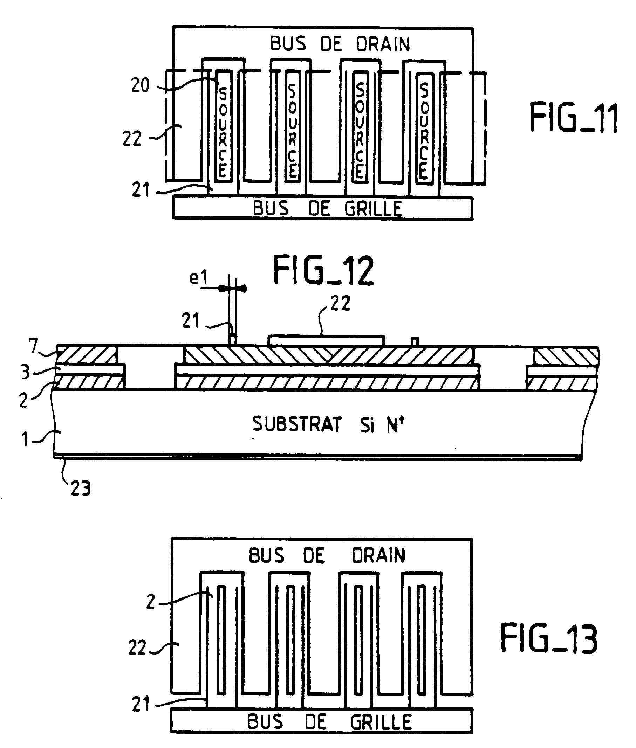

Après retrait du troisième masque (couche 6) par attaque chimique, une procédure très simplifiée de réalisation de MESFET de puissance sera réalisée. En particulier, l'étape critique du via-trou servant pour l'interconnexion des sources sera supprimée. La réalisation des contacts de sources 20 sera assurée par le GaAs N₊, qui sert de germe pour l'épitaxie latérale. Les contacts de sources (qui permettront de diminuer les résistances latérales d'accès et de court-circuiter le GaAs sous-jacent) seront déposés directememt sur les zones de germe et régions adjacentes. Les contacts de grilles et drains 21 et 22 sont définis sur le matériau déposé par épitaxie latérale. En particulier les contacts de grille 21 seront réalisés sur les zones intermédiaires dopées N. Les contacts de drain 22 seront réalisés sur les zones dopés N⁺ situées à proximité de l'emplacement des ouvertures 11 (voir figure 10). Un contact drain 22 peut être commun à deux transistors. La technologie du MESFET ainsi réalisée est entièrement face avant. De plus l'étape critique du via-trou est donc ainsi supprimée (figure 11). L'amélioration du durcissement aux rayonnements électromagnétiques de ce MESFET sera assuré par le caractère semiconducteurs sur isolant de la structure.

On peut le voir sur la figure 11, le procédé de l'invention permet de réaliser plusieurs transistors dans un même plan, l'interconnexion des drains et des grilles se faisant aisément, l'interconnexion des sources étant assurée par le substrat en Si.

Selon une variante de l'invention, représentée sur les figures 12 et 13, on élimine par gravure chimique (ou RIE) le GaAs défectueux, c'est-à-dire les germes 5 et 5′ et les régions immédiatement adjacentes, et en utilisant le même masque, on remplace ce matériau par deux contacts (24, 25), au cours dune opération de type "lift off".

Selon l'exemple de réalisation précédent on a prévu au cours de la première étape de réalisation une couche épitaxiée de GaAs fortement dopée par MBE ou MOCVD.

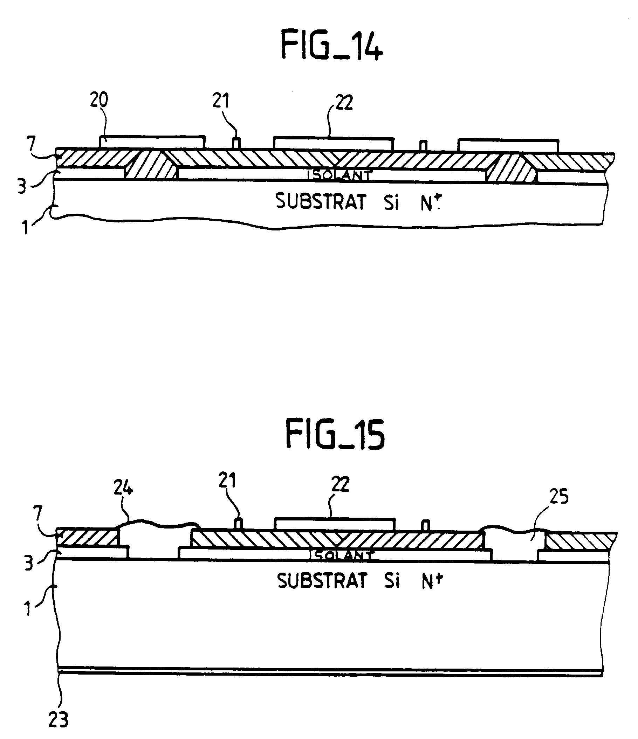

Cependant selon une variante de l'invention, on ne réalise pas cette première étape. La couche 3 d'isolant est alors réalisée directement sur le substrat et les autres étapes du procédé sont réalisées comme cela a été décrit précédemment. Comme cela a été décrit dans la demande le brevet 88 04 438, les dislocations qui se produisent par suite de l'épitaxie des éléments 5 et 5′ en GaAs sur le substrat silicium, sont réduites voire bloquées par les faces 13 et 14 des deux couches 3 et 6. On obtient ainsi une structure telle qui représentée en figure 14. La figure 15 représente de plus une variante des exemples de réalisation des figures 12 à 14. Cette variante ne comprend pas de couche 2 de GaAs et possède, à la place des éléments 5, 5, des contacts 24, 25.

A titre d'exemple, l'épaisseur de chaque couche 2, 3, 4, 6 précédente et notamment l'épaisseur de la cavité 12, ont des épaisseurs comprises entre 0,1 et 1 micromètre. La largeur de la grille indiquée e1 sur la figure 12 est d'environ 0,1 à 1 micromètre. L'espacement entre la source et le drain (entre 22 et 24) est d'environ 10 à 100 micromètres.

Les principaux avantages de la présente invention sont les suivants :
- la couche active du MESFET GaAs/Si présente une densité de dislocations beaucoup plus faible ;
- la dissipation thermique est améliorée ;
- le durcissement est amélioré ;
- le procédé de réalisation du MESFET est très sensiblement simplifié.

La description qui précède n'a été donnée qu'à titre d'exemple et d'autres variantes peuvent être envisagées sans sortir du cadre de l'invention. Notamment, on a décrit la réalisation de transistor AsGa réalisé sur substrat silicium mais on pourrait envisager d'autres matériaux semiconducteurs. De même on pourrait envisager d'avoir le substrat et le transistor réalisé tous deux avec un même matériau semiconducteur.

## Revendications

1. Procédé de réalisation d'au moins un transistor, caractérisé en ce qu'il comporte les différentes étapes suivantes :
a) réalisation sur un substrat (1) d'une première couche (2) en matériau semiconducteur d'un type déterminé et, sur cette couche, une première couche de confinement (3) en matériau isolant ;
b) réalisation d'une cavité comprise entre la première couche de confinement (3) et une deuxième couche de confinement (6), cette cavité étant définie par une première et une deuxième faces parallèles(13, 14) de ces couches, ladite cavité comportant dans son épaisseur au moins un élément en matériau semiconducteu r(5, 5′) fortement dop du type déterminé ainsi qu'une ouverture (11) traversant la deuxième couche de confinement (6) et aboutissant sensiblement perpendiculairement à l'une des faces parallèles (14), lesdites couches de confinement (3, 6) étant en matériaux tels qu'il ne peut y avoir ni nucléation, ni dépôt de semiconducteur ;
b) épitaxie latérale par ladite ouverture (11), d'un matériau de même type que celui dudit élément (5, 5′) de façon à remplir la cavité (12), le matériau épitaxié étant fortement dopé dans une première partie au début de l'épitaxie puis faiblement dopé dans une deuxième partie et enfin fortement dopé dans une troisième partie en fin d'épitaxie ;
c) retrait de la deuxième couche de confinement (6) comportant l'ouverture (11) ;
d) réalisation d'un contact de source sur la première partie du matériau épitaxié, d'un contact de grille sur la deuxième partie du matériau épitaxié et d'un contact de drain sur la troisième partie du matériau épitaxié.

2. Procédé selon la revendication 1, caractérisé en ce que l'une des couches (3) réalisant la cavité ainsi que l'élément en matériau semiconducteur dopé (5, 5′) sont situés à la surface d'un substrat (1) en matériau semiconducteur fortement dopé et le contact de source (23) est réalisé sur le substrat.

3. Procédé selon l'une des revendications 1 ou 2, caractérisé en ce qu'il comporte, après l'étape d'épitaxie latérale, une étape de gravure dudit élément (5, 5′) et une étape de dépôt dans l'emplacement ainsi gravé de contacts (24, 25).

4. Procédé selon la revendication 1, caractérisé en ce que la première couche de matériau semiconducteur (2) est réalisée sur un substrat (1) de composition différente.

5. Procédé selon la revendication 5, caractérisé en ce que le substrat est en silicium et la première couche (2) de matériau semiconducteur est à base de GaAs.

## Patentansprüche

1. Verfahren zur Herstellung mindestens eines Transistors, dadurch gekennzeichnet, daß es die folgenden Verfahrensschritte aufweist:
a) Herstellung einer ersten Schicht (2) aus Halbleitermaterial eines bestimmten Typs auf einem Substrat (1) und Herstellung einer ersten Einschließungsschicht (3) aus isolierendem Material auf dieser Schicht,
(b) Herstellung eines Hohlraums zwischen der ersten Einschließungsschicht (3) und einer zweiten Einschließungsschicht (6), wobei dieser Hohlraum durch zwei zueinander parallele Seiten (13, 14) dieser Schichten definiert wird und in seiner Dicke mindestens ein Element aus stark dotiertem Halbleitermaterial (5, 5′) des bestimmten Typs sowie eine Öffnung (11) aufweist, die die zweite Einschließungsschicht (6) durchquert und im wesentlichen senkrecht auf eine der parallelen Seiten (14) auftrifft, wobei die Einschließungsschichten (3, 6) aus solchen Materialien bestehen, daß sich keine Nukleation und keine Halbleiterschicht ergibt,
c) epitaxiales Aufwachsen eines Materials des gleichen Typs wie das des Elements (5, 5′) durch die Öffnung (11) hindurch, so daß der Hohlraum (12) gefüllt wird, wobei das aufgewachsene Material in einem ersten Bereich zu Beginn des Aufwachsvorgangs stark dotiert, dann in einem zweiten Bereich schwach dotiert und schließlich wieder in einem dritten Bereich am Ende des Aufwachsvorgangs stark dotiert ist,
d) Entfernung der zweiten Einschließungsschicht (6) mit der Öffnung (11),
e) Herstellung eines Sourcekontakts auf dem ersten Bereich des epitaxial aufgebrachten Materials, eines Gatekontakts auf dem zweiten Bereich des epitaxial aufgebrachten Materials und eines Drainkontakts auf dem dritten Bereich des epitaxial aufgebrachten Materials.

2. Verfahren nach Anspruch 1, dadurch gekennzeichnet, daß eine der Schichten (3), die den Hohlraum bilden, sowie das Element aus dotiertem Halbleitermaterial (5, 5′) an der Oberfläche eines Substrats (2) aus stark dotiertem Halbleitermaterial liegen und daß der Sourcekontakt (23) auf dem Substrat ausgebildet ist.

3. Verfahren nach einem der Ansprüche 1 oder 2, dadurch gekennzeichnet, daß es nach dem Verfahrensschritt des seitlichen epitaxialen Aufwachsens einen Verfahrensschritt des Abätzens des Elements (5, 5′) und einen Verfahrensschritt des Aufbringens von Kontakten (24, 25) an den so freigelegten Stellen aufweist.

4. Verfahren nach Anspruch 1, dadurch gekennzeichnet, daß die erste Schicht aus Halbleitermaterial (2) auf einem Substrat (1) anderer Zusammensetzung gebildet wird.

5. Verfahren nach Anspruch 4, dadurch gekennzeichnet, daß das Substrat aus Silizium und die erste Halbleiterschicht (2) auf der Basis von GaAs ausgebildet ist.

## Claims

1. Process for fabricating at least one transistor, characterized in that it comprises the following various steps:
a) production, on a substrate (1), of a first layer (2) made of a semiconductor material of a first defined type and, on this layer, a first confinement layer (3) made of insulating material;
b) production of a cavity lying between the first confinement layer (3) and a second confinement layer (6), this cavity being defined by first and second parallel faces (13, 14) of these layers, the said cavity comprising, in its thickness, at least one element (5, 5′) made of highly-doped semiconductor material of the defined type as well as an opening (11) passing through the second confinement layer (6) and terminating substantially perpendicularly to one of the parallel faces (14), the said confinement layers (3, 6) being made of materials such that there is no possibility for nucleation or deposition of semiconductor;
b) lateral epitaxy, via the said opening (11), of a material of the same type as that of the said element (5, 5′) so as to fill the cavity (12), the epitaxially grown material being highly doped in a first part at the start of the epitaxy and then weakly doped in a second part and, finally, highly doped in a third part at the end of epitaxy;
c) removal of the second confinement layer (6) comprising the opening (11);
d) production of a source contact on the first part of the epitaxially grown material, of a gate contact on the second part of the epitaxially grown material and of a drain contact on the third part of the epitaxially grown material.

2. Process according to Claim 1, characterized in that one of the layers (3) forming the cavity as well as the element (5, 5′) made of doped semiconductor material are located at the surface of a substrate (1) made of highly-doped semiconductor material and the source contact (23) is produced on the substrate.

3. Process according to one of Claims 1 and 2, characterized in that it comprises, after the lateral epitaxy step, a step of etching the said element (5, 5′) and a step of deposition of contacts (24, 25) in the location thus etched.

4. Process according to Claim 1, characterized in that the first layer (2) of semiconductor material is produced on a substrate (1) of different composition.

5. Process according to Claim 4, characterized in that the substrate is made of silicon and the first layer (2) of semiconductor material is based on GaAs.
